# EUROPEAN PATENT SPECIFICATION

(11) **EP 2 490 235 B1**
(45) Date of publication and mention of the grant of the patent: **02.04.2014**
(21) Application number: 11154603.2
(22) Date of filing: 16.02.2011
(51) Int. Cl.: H01G 9/20, H01L 51/42

(54) **Electron transporting titanium oxide layer**
Elektronentransportierende Titanoxidschicht
Couche d'oxyde de titane à transport d'électrons

(43) Date of publication of application: 22.08.2012
(73) Proprietor: IMEC, 3001 Leuven (BE)
(72) Inventor: Hadipour, Afshin, 3001 Leuven (BE)
(74) Representative: Bird, William Edward

(56) References cited:
- SUNG HEUM PARK ET AL: "Bulk heterojunction solar cells with internal quantum efficiency approaching 100%", NATURE PHOTONICS, vol. 3, 26 April 2009 (2009-04-26), pages 297-302, XP55002714, DOI: 10.1038/nphoton.2009.69
- Sung Heum Park ET AL: "Bulk heterojunction solar cells with internal quantum efficiency approaching 100% - Supplementary Information", Nature Photonics, vol. 3 26 April 2009 (2009-04-26), pages 1-7, XP55002720, DOI: 10.1038/nphoton.2009.69 Retrieved from the Internet: URL:http://www.nature.com/nphoton/journal/ v3/n5/extref/nphoton.2009.69-s1.pdf [retrieved on 2011-07-13]
- XIAOBO CHEN ET AL: "Titanium Dioxide Nanomaterials: Synthesis, Properties, Modifications, and Applications", CHEMICAL REVIEWS, vol. 107, no. 7, 23 June 2007 (2007-06-23) , pages 2891-2959, XP55002733, DOI: 10.1021/cr0500535

## Description

### Technical field of the invention

The present invention relates to the field of organic optoelectronics.

### Background of the invention

Organic solar cells typically at least comprise an anode, a cathode and an organic active layer in between said anode and said cathode. At least one of said anode and said cathode is transparent. When the organic solar cell is exposed to light, the active layer absorbs part of said light to generate both electrons and holes within said active layer. The holes are then collected at the anode and the electrons at the cathode. If the anode allows electrons to pass through it, or if the cathode allows holes to pass through, the performance of the solar cells decreases since those charges are lost by recombination. lt is therefore very important that only holes are allowed to pass through the anode and that only electrons are allowed to pass through the cathode. In order to do this, a hole transporting layer HTL (also called electron blocking layer) is placed between the anode and the active layer and an electron transporting layer ETL (also called hole blocking layer) is placed between the cathode and the active layer. The final efficiency of the solar cell depends directly on the quality of said HTL and ETL. At the anode side, usually indium tin oxide (lTO) is used in combination with poly(3,4-ethylenedioxythiophene) poly(styrenesulfonate) (PEDOT:PSS) as HTL. PEDOT-PSS can for instance be processed from solution by spin coating or spray coating. The PEDOT:PSS has a high work-function and is a very stable material. For the ETL, evaporated materials such as lithium fluorid (LiF), ytterbium (Yb) or samarium (Sm) are used. These materials have a low work-function and they oxidize very easily. In order to make a device entirely processed from solution, solution-born ETLs and HTLs needed to be developed. Since a solution for a solution-born HTL already exists (PEDOT:PSS), the next step is to find a solution-born ETL. So far, two materials have been developed which can be used as solution-processed ETL in organic solar cells: zinc oxide dispersion (ZnO) which is used by many groups and titanium oxide (TiOₓ) presented by the group of Alan Heeger in Nature Photonics, volume 3 (May 2009) 297-303 and supplementary information appended to it. All those ETL layers need some post-treatments such as thermal annealing (e.g. up to 250°C for sintering the ZnO nano-particles), processing in air (e.g. the TiO solution is taken out into air for hydrolysis and condensation processes) or UV exposure (under UV, oxides generates some extra holes. The increase of hole concentration leads to higher electron mobility and increases the conductivity) to improve their conductivity. For instance, Heeger et al. describe a polymer photovoltaic cell using a solution-based titanium oxide as an optical spacer in which the TiOₓ layer is obtained by a sol-gel procedure involving the mixing of 5 ml titanium (lV) isopropoxide with 20 ml 2-methoxyethanol and 2 ml ethanolamine at room temperature. The starting materials are injected in this order. After one hour stirring at room temperature, the mixed solution is heated at 80°C for an hour, followed by heating to 120°C for another hour. During all these procedures, the mixture is kept under N₂ atmosphere and the solution is stirred continuously at 600-800 rpm. The final step after cooling to room temperature is to add 10 ml of an alcohol selected from methanol, ethanol or isopropanol to the mixture. After a 200 fold dilution with methanol, the TiOx sol-gel of Heeger is spincasted in air on top of an active layer. The sample is then annealed at 80°C for 10 min in air before that an aluminium electrode is deposited. This procedure of thermal annealing requires heating which is energy demanding. Also, thermal annealing in air of the deposited film is not only energy demanding but also dangerous for the organic active layer (organic materials used as active layer, can be oxidized in air leading to loss of all their opto-electronics properties). There is therefore a need in the art for an improved process for providing ETL layers which do not require thermal post processing, let alone thermal post processing in air, in which the ETL layers are coated from solution, and in which the solution is not heated.

### Summary of the invention

It is an object of the present invention to provide solution-born ETL layers having sufficient conductivity for use in organic photovoltaic cells without requiring any post-treatment.

It is an advantage of embodiments of the present invention that the ETL layer does not require any thermal annealing steps.

It is an advantage of embodiments of the present invention that an efficient ETL titanium oxide layer can be obtained in an energy efficient way since no heating of the sol-gel solution and no thermal annealing (let alone thermal annealing in air) of the spin casted film is required for hydrolysis and condensation processes.

The above objective is accomplished by a method and device according to the present invention.

In a first aspect, the present invention relates to a process for making a solution for forming a titanium oxide, e.g. TiOₓ, sol-gel layer. This process is preferably performed under inert atmosphere.

In an embodiment, said process involves the mixing of:
- an acid,
- water,
- a water-miscible alcohol,
- a titanium oxide precursor, and
- a compound of general formula (l)

N(R¹)(R²)(R³) (I)

wherein R¹ is selected from the list consisting of C₁-C₄ linear alkyl groups and C₃-C₄ branched alkyl groups wherein any of said alkyl group may be optionally substituted by a group Y selected from the list consisting of ―NH₂, -SH, -OH, -NR⁴R⁵ -SR', -OR", wherein R⁴, R⁵, R' and R" are selected from the list consisting of C₁-C₄ linear alkyl groups and C₃-C₄ branched alkyl groups, wherein R² and R³ are independently selected from the list consisting of H, C₁-C₄ linear alkyl groups and C₃-C₄ branched alkyl groups wherein any of said alkyl group may be optionally substituted by a group Y selected from the list consisting of ―NH₂, -SH, -OH, -NR⁴R⁵, -SR', -OR", wherein R⁴, R⁵, R' and R" are selected from the list consisting of C₁-C₄ linear alkyl groups and C₃-C₄ branched alkyl groups, said mixing comprising the steps of:
a) mixing said acid with said water thereby obtaining a first mixture,
b) mixing said first mixture with said water miscible alcohol, thereby obtaining a second mixture,
c) mixing said compound of general formula (I) to said second mixture, thereby obtaining a third mixture,
d) waiting enough time for said third mixture to reach room temperature, e.g. from 10 to 15 minutes,
e) adding said titanium oxide, e.g. TiOx, precursor to said third mixture, thereby obtaining said solution.

In formula (I), R² and R³ are independently preferably H.

In formula (I), R¹ is preferably (CH₂)₂-Y.

In formula (I), Y is preferably OH.

Preferably, N(R¹)(R²)(R³) is ethanolamine.

The titanium oxide of the different aspects of the present invention preferably has an anatase phase.

Examples of titanium oxide precursors include, but are not limited to, titanium tetraisopropoxide, titanium tetrabutoxide, titanium tetraethoxide, titanium tetraoxychloride, titanium tetrachloride and titanium n-propoxide. The titanium oxide precursor is preferably a titanium alkoxide, preferably a titanium (IV) alkoxide of general formula (II):

Ti(OR)₄ (II)

wherein R is selected from C₁-C₄ linear alkyl or C₃-C₄ branched alkyl chains. Most preferably, the titanium oxide precursor is titanium (IV) isopropoxide.

By water miscible alcohol, it is meant an organic compound comprising at least one alcohol function and which is soluble in water in all proportions at room temperature and 1 atm. The water miscible alcohol preferably has the general formula (III):

R-OH (III)

wherein R is selected from C₁-C₃ linear alkyl and C₃ branched alkyl groups. Preferably, said alcohol is ethanol.

The acid can be any acid but is preferably an organic acid. The pKa of the acid may for instance be from -2 to 12. More preferably, it has the general formula (IV):

R-COOH (IV),

wherein R is selected from C₁-C₄ linear alkyl and C₃-C₄ branched alkyl groups.

Preferably, the acid is acetic acid.

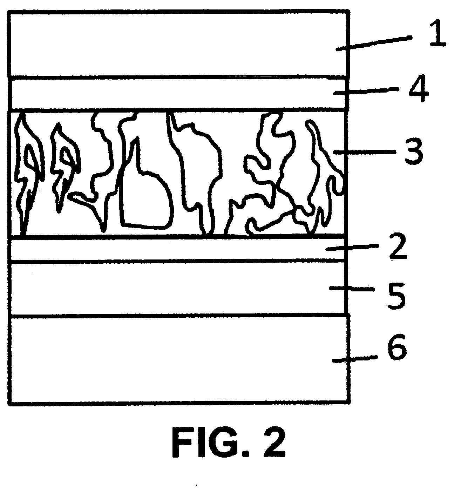

In a preferred embodiment, in step (b) said first mixture is further mixed with a carbohydrate. Preferably said carbohydrate is a sugar alcohol, preferably, said sugar alcohol may have 6 carbons and most preferably it is D-sorbitol. Adding a carbohydrate is advantageous because it increases the adherence of the layer to a substrate. It is particularly advantageous in the reverse devices (see Fig. 2) since the titanium oxide layer must there be deposited on the inorganic conductive oxide (e.g. ITO) layer on which adherence is typically problematic.

In an embodiment, a surfactant may be added to the mixture at any step of said process. This is advantageous as it increases the ability of the solution to wet a substrate.

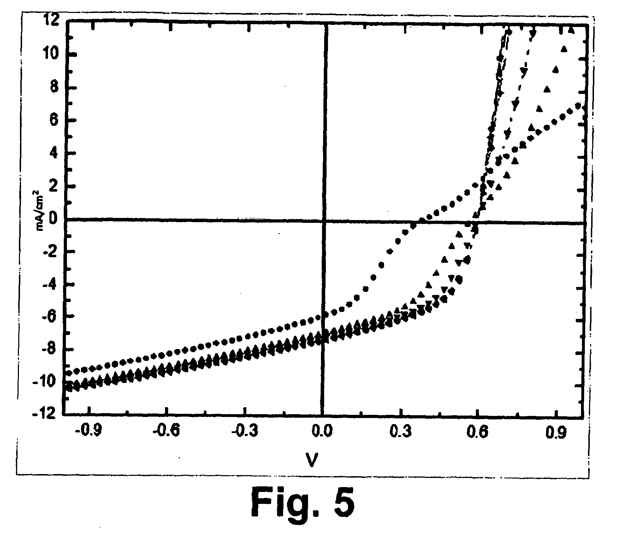

Preferably, the solution obtained after step (e) may be clear. In other words, it is preferably not turbid. Turbid solutions have been shown by the inventor to lead to lower efficiencies and to devices only showing maximal performance after photoactivation (see Fig. 5).

In a preferred embodiment of the first aspect of the present invention, the relative proportions of the above-mentioned constituents of the solution are as follow:
Alcohol: from 5.0 to 20 mol. equivalents and preferably from 8 to 13 mol. equivalents. There is no real upper limit for the amount of alcohol present in the final solution since once produced according to the first aspect of the present invention, the solution can be diluted before use (e.g. before deposition). Before use, it is advantageous to dilute the solution. The dilution depends on the target thickness of the layer. In order to reach a target final thickness for the deposited (e.g. spin casted) film, one can play on the solution dilution and/or on the deposition parameters (e.g. by adopting a particular spin program). Different spin programs and also different processing methods such as spray coating or injection printing of the solution are better performed at different dilutions. Optimum preferred thickness for the titanium oxide layer is from 5 to 20 nm and most preferably from 7 to 13 nm (e.g. about 10nm). In an embodiment, the solution is diluted between 5 and 15 vol.% (e.g. to 10 Vol. % (1ml solution + 9ml alcohol)) in combination with spinning at from 800 to 1200 rpm (e.g. 1000 rpm) for 40 to 80 seconds (e.g. 60 seconds) to reach 5 to 15 nm thickness (e.g. about 10 nm). Preferably, the solution according to the first aspect of the present invention comprises at most 1000 mol. equivalents of the water-miscible alcohol.

Carbohydrate: from 5*10⁻² to 2*10⁻¹ mol. equivalents, preferably from 8*10⁻² to 1.2*10⁻¹ mol. equivalents.

Water: from 1 to 5 mol. equivalents, preferably from 2.0 to 2.6 mol equivalents. Acid: from 0.5 to 3.0 mol. equivalents, preferably from 1.0 to 1.8 mol equivalents.

Compound of general formula (I): from 2.5 mol. equivalents to 10 mol. equivalents, preferably from 4.0 to 6.4 mol. equivalents,

Titanium oxide precursor: from 0.5 to 2 mol. equivalents, preferably from 0.8 to 1.2 mol. equivalents.

In a preferred embodiment, this process is performed at room temperature, e.g. from 18 to 25°C.

In a preferred embodiment, this process is performed under an inert atmosphere. For instance, it may be performed in a glove box filled in with an inert gas such as N₂ or Ar.

In a preferred embodiment, the process may further comprise the step of
f) waiting at least 90 minutes before to perform step (b) of the third aspect or before to further dilute with a water miscible alcohol said solution obtained in step (e) of the first aspect.

In an embodiment of the first aspect, said mixing steps are performed at 300 to 1400 rpm.

In a preferred embodiment of the first aspect, the pH of the solution obtained after step (e) is from 8.0 to 10.0

In a second aspect not forming part of the invention, the application relates to a solution obtainable by the process of any embodiment of the first aspect optionally followed by a dilution in a water miscible alcohol. This dilution can for instance be from two-fold to twenty-fold, preferably from five-fold to fifteen-fold (by volume). It is preferred to dilute the solution before to perform step (b) of the third aspect.

In a third aspect not forming part of the invention, the application relates to a process for making a device, said process comprising the steps of:
a) providing a substrate, and
b) applying a solution according to said second aspect to said substrate, preferably under an inert atmosphere.

Preferably, said process according to the third aspect may be performed at room temperature.

In a preferred embodiment of the third aspect, the solution of the second aspect is allowed to age at room temperature for at least 90 minutes after step (e) of the first aspect before to perform said step of diluting said solution and/or of applying said (optionally dilute) solution to said substrate.

In a preferred embodiment, the process of the third aspect does not comprise an annealing step, an oxygen treatment or a photo-doping with UV light after step (b) of the process for making a device according to the third aspect.

In an embodiment of the process of the third aspect, step (b) is performed via spin coating, spray coating or inkjet printing.

In a fourth aspect, not forming part of the invention, the application relates to a device. The device is preferably an opto-electronic device. More preferably, it is a photovoltaic device and/or an organic opto-electronic device. Most preferably, it is an organic photovoltaic device.

The device of the fourth aspect is obtainable by a process of the third aspect of the present invention.

The device according to the fourth aspect comprises a titanium oxide layer, e.g. a titanium suboxide layer. Typically, this titanium oxide layer serves as an electron transporting layer.

The ratio oxygen to titanium in the titanium oxide layer, [d1] typically takes values ranging from 1.1 to 1.9.

When the device of the fourth aspect is an organic photovoltaic cell, it typically comprises a transparent substrate (e.g. glass), a transparent anode on top of said transparent substrate (the anode is typically indium tin oxide (ITO)), an HTL on top of said anode, an active layer on top of said HTL, an ETL on top of the active layer and a cathode on top of the ETL (the cathode can for instance be an Al or a Ag cathode). This type of structures is called "conventional". Alternatively, the device may be a "reversed" device where the ETL is on top of the cathode (e.g. ITO is here used as a cathode), where the active layer is on top of the ETL, where the HTL is on top of the active layer and where the anode is on top of the HTL (the anode can here be e.g. a Au, Al or Ag layer).

In a preferred embodiment, the device according to the fourth aspect further comprises a cathode and an anode.

In a preferred embodiment of the fourth aspect, said cathode is an aluminium cathode.

In a preferred embodiment of the fourth aspect, said electron transporting layer has a thickness of from 5 nm to 40 nm, preferably from 10 to 35 nm, more preferably from 20 to 30 nm.

In a preferred embodiment of the fourth aspect, said electron transporting layer comprises a surfactant.

In a preferred embodiment of said fourth aspect, said electron transporting layer comprises a carbohydrate as defined in any embodiment of the first aspect the present invention.

In a preferred embodiment of said fourth aspect, said electron transporting layer comprises ethanolamine.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a diagrammatic view of a conventional device according to an embodiment of the present invention.
Fig. 2 is a diagrammatic view of a reverse device according to an embodiment of the present invention.
Fig. 3 is a graph of the current density versus voltage in a conventional device according to an embodiment of the present invention (squares) and in a conventional device according to the prior art (triangles), both when directly measured after having been kept in the dark beforehand (d) and when measured after exposure (i).
Fig. 4 is a graph of the current density versus voltage in a reverse device according to an embodiment of the present invention, both when directly measured after having been kept in the dark beforehand (squares) and when measured after exposure to UV irradiation (circles).
Fig. 5 is a graph of the current density versus voltage in a reverse device according to a comparative embodiment build from an improper turbid solution obtained from the use of to much acid, both when directly measured after having been kept in the dark beforehand (diamonds) and when measured after various exposure times to UV irradiation.
Fig. 6 is a graph of the current density versus voltage in a reverse device according to an embodiment of the present invention, both when directly measured after having been kept in the dark beforehand (squares) and when measured after exposure to UV irradiation (circles).

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

### Definitions

The term titanium suboxide, as used in disclosing the present invention, means a titanium oxide with a O/Ti atomic ratio between 1 and 2, preferably between 1.1 and 1.9. Typically, said titanium suboxide has electron-conducting properties.

The term clear when applied to solutions, as used in disclosing the present invention, means that no cloudiness is observable with the human eye.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

### Example 1: solutions according to embodiments of the present invention

### Example 1-a:

A 4 ml bottle was placed on a stirring plate (600 rpm) in a glove box kept at room temperature under inert atmosphere. 1 ml of ethanol was mixed with 3 mg of D-sorbitol until all sorbitol was dissolved. The resulting mixture (mixture X) was clear.

In another bottle, 1 part per volume of acetic acid was mixed with 0.5 parts per volume of distilled water. The resulting mixture was called mixture Y. 0.2 ml of mixture Y was added to mixture X, thereby obtaining mixture Z. 0.5 ml ethanolamine was added to mixture Z. This resulted in the generation of heat and smoke. After a several minutes, when the temperature had returned to room temperature, 0.5 ml of isopropoxide IV titanium was slowly added to the above mentioned mixture. The mixture was mixed further on the stirring plate for a couple of hours. The final solution was totally clear.

In this example, the proportions of each constituent of the solution were as follow:
Alcohol: 11.6 parts per weight, 10.6 mol. equivalents
Carbohydrate: 44.8 parts per weight, 10 mol. equivalents
Water: 1.0 parts per weight, 2.3 mol. equivalents
Acid: 2.0 parts per weight, 1.4 mol. equivalents
Compound of general formula (I): 7.6 parts per weight, 5.2 mol equivalents.
Titanium oxide precursor: 7.0 parts per weight, 1 mol. equivalents

### Example 1-b:

In a 4 ml bottle placed on a stirring plate (600 rpm) in a glove box kept at room temperature under inert atmosphere, 1 part per volume of acetic acid was mixed with 0.5 parts per volume of distillated water. The resulting mixture was called mixture Y.1 ml ethanol was added to 0.2 ml of mixture Y, thereby obtaining mixture Z.
0.5 ml ethanolamine was added to mixture Z. This resulted in the generation of heat and smoke. After a couple of minutes, when the temperature had returned to room temperature, 0.5 ml of isopropoxide IV titanium was slowly added to the above mentioned mixture. The mixture was mixed further on the stirring plate for two hours. The final solution was totally clear.

This solution had the same properties as the solution of example 1 except that it adhered more poorly to the ITO layer.

### Example 2: fabrication of a conventional cell

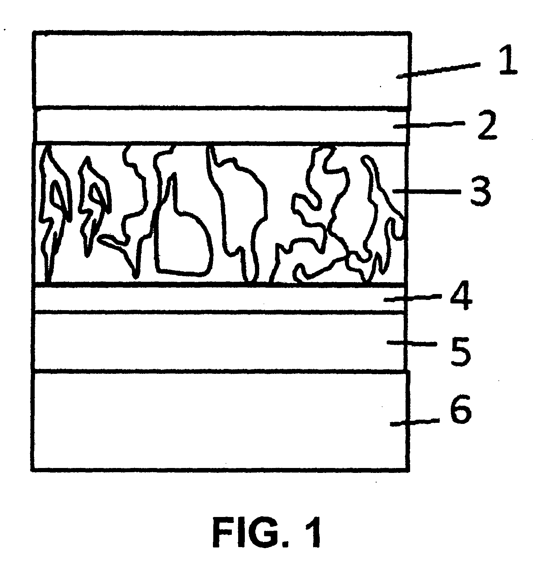

Referring to Fig. 1, a stack made of a glass substrate 6, an ITO anode 5, a HTL 4 and an active medium 3 was first prepared. Then, in a glove box under N₂ atmosphere, the solution of example 1-a was diluted fivefold with ethanol and spin coated onto the active layer 3 made of a poly(3-hexylthiophene): phenyl-C 61-butyric acid methyl ester (P3HT:PC60BM) bulk heterojunction. The obtained titanium oxide layer 2 was not exposed to any further treatment. A cathode 1 was finally evaporated onto the titanium oxide layer. The resulting device had the following structure: ITO/PEDOT/P3HT:PC60BM (250 nm)/titanium oxide(10 nm)/Al(100 nm).

### Comparative Example 1

A 4 ml bottle was placed on a stirring plate (600 rpm) in a glove box kept at room temperature under inert atmosphere. 1 ml of ethanol was mixed with 3 mg of D-sorbitol until all the sorbitol was dissolved. The resulting mixture (mixture X) was clear.

In another bottle, 1 part per volume of acetic acid was mixed with 0.5 parts per volume of distilled water. The resulting mixture was called mixture Y.
0.6 ml of mixture Y was added to mixture X, thereby providing mixture Z.
0.5 ml ethanolamine was added to mixture Z. This resulted in the generation of heat and smoke. After a several minutes, when the temperature had returned to room temperature, 0.5 ml of isopropoxide IV titanium was added slowly to the above mentioned mixture. The mixture was mixed further on the stirring plate for a couple of hours. The final solution was turbid.

### Comparative example 2

The same device as for example 2 was built except that the titanium oxide layer 2 was replaced by an evaporated Yb layer 2. The resulting device had the following structure: ITO/PEDOT/P3HT:PC60BM (250 nm)/Yb (50 nm)/Al (100 nm).

### Comparison of the devices of example 2 and comparative example 2.

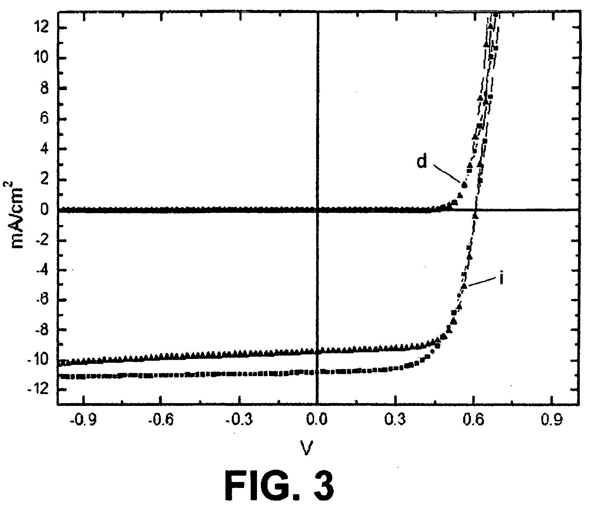

Referring to Fig. 3, the d lines correspond to current density vs voltage measures made in the dark while the i lines correspond to measurements made under exposure to UV irradiation. The squares are points corresponding to example 2 while the triangles are points corresponding to comparative example 2. The fill factor for the device of example 2 was 64.0% and the efficiency of the device was 4.17%. The fill factor for the device of comparative example 2 was 71.1 % and the efficiency of the device was 4.07%. The current of the device according to example 2 is clearly higher than the current of the device according to comparative example 2. This is believed to be due to the titanium oxide layer fulfilling the double function of ETL and optical spacer, thereby improving the light distribution inside the active layer and producing a higher photocurrent.

### Example 3: Fabrication of a reverse cell

Referring to Fig. 2, a stack made of a glass substrate 6 and an ITO cathode 5 was first prepared. Under inert atmosphere (N₂, glove box), a titanium oxide solution according to example 1-a but diluted fivefold with ethanol was then spin-coated on said ITO cathode 5 and allowed to dry without exposition to any further treatment, thereby forming titanium oxide gel 2. An active layer 3 composed of a mixture of poly(3- Hexylthiophene) and phenyl-C 61-butyric acid methyl ester was then spin-coated on said titanium oxide gel 2. The active layer 3 was allowed to dry. A HTL 4 was then spin-coated onto said active layer 3 and allowed to dry. A 100 nm Al anode was then evaporated onto said HTL 4. The resulting device had the following structure: ITO/titanium oxide(10-12 nm)/P3HT:PC60BM(250 nm)/PEDOT/ Al(100nm).

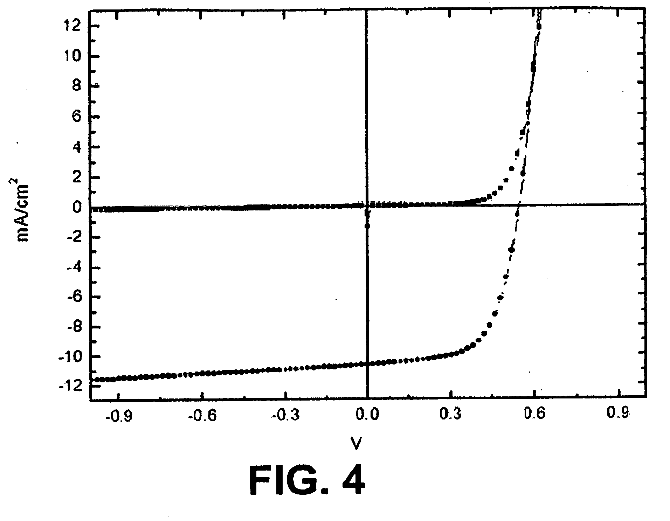

Referring to Fig. 4, the squares correspond to the current density vs voltage measures made in the dark while the circles correspond to measurements made under exposure to UV irradiation. The fill factor for the device was 62.0% and the efficiency of the device was 3.63%.

### Comparative example 3

The same procedure as followed for example 3 was used here but the solution of comparative example 1 was used instead of the solution of example 1 and a 80 nm thick instead of a 250 nm thick P3HT:PCBM active layer was used. Referring now to Fig. 5, it is shown that when the turbid solution of comparative example 1 is used, the first measurement (before exposure, circles) shows a low quality solar cell with a low fill factor of 31.6% and a low efficiency of 0.66%. Only after exposure to UV light does the performance of the device improve.

After 5 s of UV-exposure, the fill factor was at 45.5% and the efficiency was at 1.67% (upward oriented triangles).

After 15 s of UV-exposure, the fill factor was at 49.8% and the efficiency was at 1.99% (downward oriented triangles).

After 60 s of UV-exposure, the fill factor was at 50.1% and the efficiency was at 2.16% (diamonds).

After 2, 3 and 4 min of UV-exposure, the fill factor was at 50.1 % and the efficiency was at 2.17% (respectively leftward oriented triangles, rightward oriented triangles and hexagones).

Even after UV-exposure, the maximal attained quality was lower than when the clear solution of example 1 was used (see Fig. 4). The turbid solution of comparative solution 1 led to an efficiency which never achieved the performance of the device when the clear solution of example 1 was used.

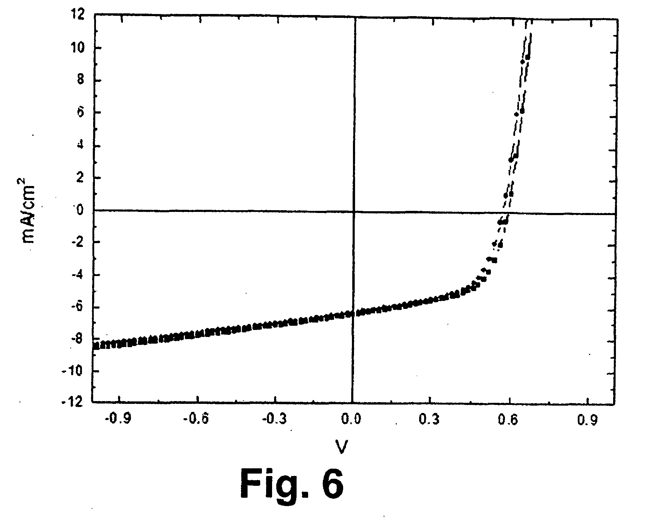

Referring now to Fig. 6, it is shown that the directly measured cell (i.e. when the cell was kept in the dark up to the time of the measurement) and the cell which was UV-exposed for 1 min before measurements attain a constant efficiency. This shows that when the solution was clear without aggregation (case of the solution of examples 1), photo-doping was not needed.

## Claims

1. A process for making a solution for forming a titanium oxide sol-gel layer, said process being preferably performed under inert atmosphere, said process involving the mixing of:
- from 0.5 to 3.0 mol. equivalents, preferably from 1.0 to 1.8 mol equivalents of an acid,
- from 1.0 to 5.0 mol. equivalents, preferably from 2.0 to 2.6 mol equivalents of water,
- from 5.0 to 20 mol. equivalents, preferably form 8 to 13 mol. equivalents of a water-miscible alcohol,
- from 0.5 to 2 mol. equivalents, preferably from 0.8 to 1.2 mol. equivalents of a titanium oxide precursor, and
- from 2.5 to 10 mol. equivalents, preferably from 4.0 to 6.4 mol. equivalents of a compound of general formula (I)
N(R¹)(R²)(R³) (I)
wherein R¹ is selected from the list consisting of C₁-C₄ linear alkyl groups and C₃-C₄ branched alkyl groups wherein any of said alkyl group may be optionally substituted by a group Y selected from the list consisting of - NH₂, -SH, -OH, -NR⁴R⁵, -SR', -OR", wherein R⁴, R⁵, R' and R" are selected from the list consisting of C₁-C₄ linear alkyl groups and C₃-C₄ branched alkyl groups, wherein R² and R³ are independently selected from the list consisting of H, C₁-C₄ linear alkyl groups and C₃-C₄ branched alkyl groups wherein any of said alkyl group may be optionally substituted by a group Y selected from the list consisting of -NH₂, -SH, -OH, -NR⁴R⁵, -SR', -OR", wherein R⁴, R⁵, R' and R" are selected from the list consisting of C₁-C₄ linear alkyl groups and C₃-C₄ branched alkyl groups, said mixing comprising the steps of:
a) mixing said acid with said water thereby obtaining a first mixture,
b) mixing said first mixture with said water-miscible alcohol, thereby obtaining a second mixture,
c) mixing said compound of general formula (I) to said second mixture, thereby obtaining a third mixture,
d) waiting enough time for said third mixture to reach room temperature, e.g. from 10 to 15 minutes,
e) adding said titanium oxide precursor to said third mixture, thereby obtaining said solution.

2. The process according to claim 1, wherein in step (b) said first mixture is further mixed with a carbohydrate, preferably D-sorbitol.

3. The process according to claim 2, wherein said carbohydrate is present in an amount from 5*10⁻² to 2*10⁻¹ mol. equivalents, preferably from 8*10⁻² to 1.2*10⁻¹ mol. equivalents.

4. The process according to any one of the preceding claims, performed at room temperature.

5. The process according to anyone of the preceding claims, wherein the solution obtained in step (e) is clear.

6. The process according to anyone of the preceding claims, wherein said titanium oxide precursor is a titanium alkoxide, preferably a titanium (IV) alkoxide of general formula (II):
Ti(OR)₄ (II)
wherein R is selected from C₁-C₄ linear alkyl or C₃-C₄ branched alkyl chains.

7. The process according to any one of the preceding claims, wherein said titanium oxide precursor is titanium (IV) isopropoxide.

8. The process according to any one of the preceding claims, wherein said water-miscible alcohol has the general formula
R-OH (III)
wherein R is selected from C₁-C₃ linear alkyl and C₃ branched alkyl groups.

9. The process according to claim 8, wherein said water-miscible alcohol is ethanol.

10. The process according to any one of the preceding claims, wherein said acid is an organic acid, preferably having has the general formula (IV)
R-COOH (IV),
wherein R is selected from C₁-C₄ linear alkyl and C₃-C₄ branched alkyl groups.

11. The process according to claim 10, wherein said acid is acetic acid.

## Patentansprüche

1. Verfahren zur Herstellung einer Lösung zur Bildung einer Titanoxid-Sol-Gelschicht, wobei das Verfahren vorzugsweise unter einer inerten Atmosphäre ausgeführt wird, wobei das Verfahren das Mischen von:
- 0,5 bis 3,0 molaren Äquivalenten, vorzugsweise 1,0 bis 1,8 molaren Äquivalenten einer Säure;
- 1,0 bis 5,0 molaren Äquivalenten, vorzugsweise 2,0 bis 2,6 molaren Äquivalenten Wasser;
- 5,0 bis 20 molaren Äquivalenten, vorzugsweise 8 bis 13 molaren Äquivalenten eines wassermischbaren Alkohols,
- 0,5 bis 2 molaren Äquivalenten, vorzugsweise 0,8 bis 1,2 molaren Äquivalenten eines Titanoxidvorläufers und
- 2,5 bis 10 molaren Äquivalenten, vorzugsweise 4,0 bis 6,4 molaren Äquivalenten einer Verbindung der allgemeinen Formel (I)
N(R¹) (R²) (R³) (I)
beinhaltet, wobei R¹ aus der Liste bestehend aus C₁-C₄ linearen Alkylgruppen und C₃-C₄ verzweigten Alkylgruppen ausgewählt ist, wobei jede Alkylgruppe optional durch eine Gruppe Y substituiert sein kann, die aus der Liste bestehend aus -NH₂, -SH, -OH, -NR⁴R⁵, -SR', -OR" ausgewählt ist, wobei R⁴, R⁵, R' und R" aus der Liste bestehend aus C₁-C₄ linearen Alkylgruppen und C₃-C₄ verzweigten Alkylgruppen ausgewählt sind, wobei R² und R³ unabhängig aus der Liste bestehend aus H, C₁-C₄ linearen Alkylgruppen und C₃-C₄ verzweigten Alkylgruppen ausgewählt sind, wobei jede Alkylgruppe optional durch eine Gruppe Y substituiert sein kann, die aus der Liste bestehend aus -NH₂, -SH, -OH, -NR⁴R⁵, -SR', -OR" ausgewählt ist, wobei R⁴, R⁵, R' und R" aus der Liste bestehend aus C₁-C₄ linearen Alkylgruppen und C₃-C₄ verzweigten Alkylgruppen ausgewählt sind, wobei das Mischen folgende Schritte umfasst:
a) Mischen der Säure mit dem Wasser, wodurch ein erstes Gemisch erhalten wird,
b) Mischen des ersten Gemisches mit dem wassermischbaren Alkohol, wodurch ein zweites Gemisch erhalten wird,
c) Mischen der Verbindung der allgemeinen Formel (I) mit dem zweiten Gemisch, wodurch ein drittes Gemisch erhalten wird,
d) Warten über eine ausreichende Zeit, damit das dritte Gemisch Raumtemperatur erreicht, z.B. 10 bis 15 Minuten,
e) Hinzufügen des Titanoxidvorläufers zu dem dritten Gemisch, wodurch die Lösung erhalten wird.

2. Verfahren nach Anspruch 1, wobei in Schritt (b) das erste Gemisch ferner mit einem Kohlenhydrat, vorzugsweise D-Sorbitol gemischt wird.

3. Verfahren nach Anspruch 2, wobei das Kohlenhydrat in einer Menge von 5*10⁻² bis 2*10⁻¹ molaren Äquivalenten vorhanden ist, vorzugsweise von 8*10⁻² bis 1,2*10⁻¹ molaren Äquivalenten.

4. Verfahren nach einem der vorangehenden Ansprüche, das bei Raumtemperatur durchgeführt wird.

5. Verfahren nach einem der vorangehenden Ansprüche, wobei die in Schritt (e) erhaltene Lösung klar ist.

6. Verfahren nach einem der vorangehenden Ansprüche, wobei der Titanoxidvorläufer ein Titanalkoxid, vorzugsweise ein Titan(IV)alkoxid der allgemeinen Formel (II):
Ti(OR)₄ (II)
ist, wobei R aus C₁-C₄ linearen Alkyl- oder C₃-C₄ verzweigten Alkylketten ausgewählt ist.

7. Verfahren nach einem der vorangehenden Ansprüche, wobei der Titanoxidvorläufer Titan(IV)isopropoxid ist.

8. Verfahren nach einem der vorangehenden Ansprüche, wobei der wassermischbare Alkohol die allgemeine Formel
R-OH (III)
hat, wobei R aus C₁-C₃ linearen Alkyl- und C₃ verzweigten Alkylgruppen ausgewählt ist.

9. Verfahren nach Anspruch 8, wobei der wassermischbare Alkohol Ethanol ist.

10. Verfahren nach einem der vorangehenden Ansprüche, wobei die Säure eine organische Säure ist, die vorzugsweise die allgemeine Formel (IV)
R-COOH (IV)
hat, wobei R aus C₁-C₄ linearen Alkyl- oder C₃-C₄ verzweigten Alkylketten ausgewählt ist.

11. Verfahren nach Anspruch 10, wobei die Säure Essigsäure ist.

## Revendications

1. Processus pour fabriquer une solution pour former une couche de sol-gel d'oxyde de titane, ledit processus étant de préférence effectué sous une atmosphère inerte, ledit processus impliquant le mélange de :
- de 0,5 à 3,0 équivalents mole, de préférence de 1,0 à 1,8 équivalents mole d'un acide,
- de 1,0 à 5,0 équivalents mole, de préférence de 2,0 à 2,6 équivalents mole d'eau,
- de 5,0 à 20 équivalents mole, de préférence de 8 à 13 équivalents mole d'un alcool miscible dans l'eau,
- de 0.5 à 2 équivalents mole, de préférence de 0,8 à 1,2 équivalents mole d'un précurseur d'oxyde de titane, et
- de 2,5 à 10 équivalents mole, de préférence de 4,0 à 6,4 équivalents mole d'un composé de formule générale (I)
N(R¹)(R²)(R³) (I)
dans laquelle R¹ est sélectionné à partir de la liste constituée par des groupes alkyle linéaire en C₁-C₄ et des groupes alkyle ramifié en C₃-C₄ dans lesquels l'un quelconque desdits groupes alkyle peut être substitué de manière facultative par un groupe Y sélectionné à partir de la liste constituée par -NH₂, -SH, -OH, -NR⁴R⁵, -SR', -OR", dans lesquels R⁴, R⁵, R' et R" sont sélectionnés à partir de la liste constituée par des groupes alkyle linéaire en C₁-C₄ et des groupes alkyle ramifié en C₃-C₄, dans lesquels R² et R³ sont indépendamment sélectionnés à partir de la liste constituée par H, des groupes alkyle linéaire en C₁-C₄ et des groupes alkyle ramifié en C₃-C₄ dans lesquels l'un quelconque desdits groupes alkyle peut être substitué de manière facultative par un groupe Y sélectionné à partir de la liste constituée par -NH₂, -SH, -OH, -NR⁴R⁵, -SR', -OR", dans lesquels R⁴, R⁵, R' et R" sont sélectionnés à partir de la liste constituée par des groupes alkyle linéaire en C₁-C₄ et des groupes alkyle ramifié en C₃-C₄, ledit mélange comprenant les étapes de :
a) mélange dudit acide avec ladite eau obtenant de ce fait un premier mélange,
b) mélange dudit premier mélange avec ledit alcool miscible dans l'eau, obtenant de ce fait un second mélange,
c) mélange dudit composé de formule générale (I) audit second mélange, obtenant de ce fait un troisième mélange,
d) attente d'un temps suffisamment long pour que ledit troisième mélange atteigne la température ambiante, par exemple de 10 à 15 minutes,
e) ajout dudit précurseur d'oxyde de titane audit troisième mélange, obtenant de ce fait ladite solution.

2. Processus selon la revendication 1, dans lequel, dans l'étape (b) ledit premier mélange est en outre mélangé avec un hydrate de carbone, de préférence du D-sorbitol.

3. Processus selon la revendication 2, dans lequel ledit hydrate de carbone est présent en une quantité de 5 × 10⁻² à 2 × 10⁻¹ équivalents mole, de préférence de 8 × 10⁻² à 1,2 × 10⁻¹ équivalents mole.

4. Processus selon l'une quelconque des revendications précédentes, effectué à température ambiante.

5. Processus selon l'une quelconque des revendications précédentes, dans lequel la solution obtenue dans l'étape (e) est claire.

6. Processus selon l'une quelconque des revendications précédentes, dans lequel ledit précurseur d'oxyde de titane est un alcoxyde de titane, de préférence un alcoxyde de titane (IV) de formule générale (II) :
Ti(OR)₄ (II)
dans laquelle R est sélectionné à partir de chaînes alkyle linéaire en C₁-C₄ ou alkyle ramifié en C₃-C₄.

7. Processus selon l'une quelconque des revendications précédentes, dans lequel ledit précurseur d'oxyde de titane est de l'isopropoxyde de titane (IV).

8. Processus selon l'une quelconque des revendications précédentes, dans lequel ledit alcool miscible dans l'eau a la formule générale
R-OH (III)
dans laquelle R est sélectionné à partir des groupes alkyle linéaire en C₁-C₃ et alkyle ramifié en C₃.

9. Processus selon la revendication 8, dans lequel ledit alcool miscible dans l'eau est de l'éthanol.

10. Processus selon l'une quelconque des revendications précédentes, dans lequel ledit acide est un acide organique, de préférence ayant la formule générale (IV)
R-COOH (IV),
dans laquelle R est sélectionné à partir des groupes alkyle linéaire en C₁-C₄ et alkyle ramifié en C₃-C₄.

11. Processus selon la revendication 10, dans lequel ledit acide est de l'acide acétique.
